# EUROPEAN PATENT APPLICATION

(11) **EP 2 650 978 A1**
(43) Date of publication of application: **16.10.2013**
(21) Application number: 11847331.3
(22) Date of filing: 08.09.2011
(51) Int. Cl.: H01R 13/52, H01L 31/042

(54) **SOLAR CELL MODULE AND CONNECTOR FOR SOLAR CELL MODULE**

(30) Priority: 08.12.2010 JP 2010274017
(71) Applicant: Kabushiki Kaisha Toshiba, Minato-ku Tokyo 105-8001 (JP)
(72) Inventor: SHINOHARA, Hirofumi, Tokyo 183-8511 (JP)
(74) Representative: HOFFMANN EITLE
(86) International application number: PCT/JP2011/070489
(87) International publication number: WO 2012/077393

(57) **Abstract**

A solar module and a solar module connector which is less susceptible to invasion of foreign materials, such as sea salt particles, into the connector without putting the solar module in an output short-circuit state. The connector 22 and 26 of solar module 3 comprising: a pin insert 31 configured to electrically connect with one of a positive electrode and a negative electrode; a jack housing 32 configured to surround the pin insert 31; a socket insert 35 configured to electrically connect with another of the positive electrode and the negative electrode; and a plug housing 36 configured to surround the socket insert 35 and to be engageable with the jack housing 32 in a first engagement state where the pin insert 31 and the socket insert 35 are covered in a non-conductive state and in a generally airtight manner in cooperation with the jack housing 32 or in a second engagement state where the pin insert 31 and the socket insert 35 are covered in a conductive state and in a generally airtight manner.

## Description

### FIELD

Embodiments described herein relate to a solar module and a solar module connector.

### BACKGROUND

A solar energy generation system includes a solar module which generates direct current (DC) power upon reception of light, and an inverter which converts the DC power into alternating-current (AC) power and transmits the AC power to a power grid.

The solar energy generation system also includes a plurality of solar modules in order to acquire desired power generation capacity. A circuit including a plurality of solar modules connected in series is referred to as a solar module string, and a circuit including a plurality of solar module strings connected in parallel is referred to as a solar array.

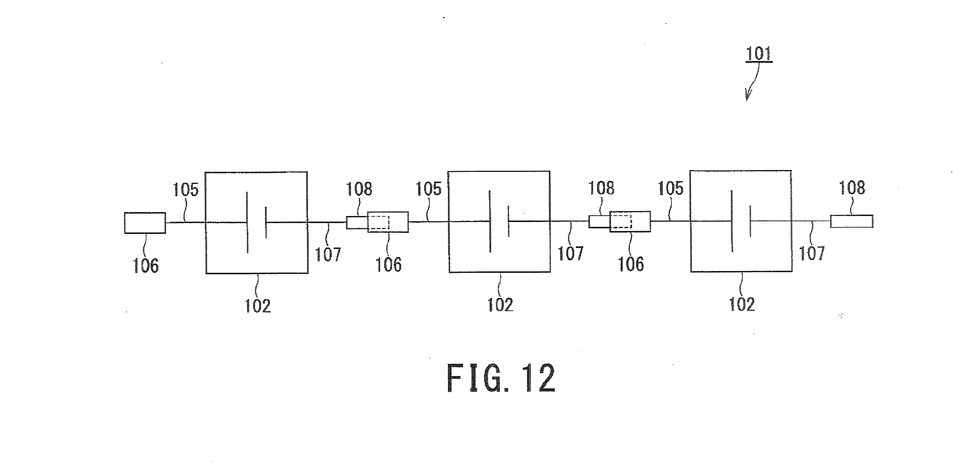

Fig. 12 is a schematic view showing a solar module string.

As shown in Fig. 12, a solar module string 101 includes a plurality of solar modules 102 electrically connected in series.

Each of the solar modules 102 includes a positive electrode cable 105 electrically connected to a positive electrode, a positive electrode connector 106 positioned at a top end of the positive electrode cable 105, a negative electrode cable 107 electrically connected to a negative electrode, and a negative electrode connector 108 positioned at a top end of the negative electrode cable 107.

The solar module string 101 includes a series circuit of the solar modules 102 in which the positive electrode connector 106 is connected to the negative electrode connector 108 between adjacent solar modules 102 one after another.

### Citation List

### Patent Document

Patent Document 1: Japanese Patent Laid-Open No. 2003-229199

### BRIEF DESCRIPTION OF THE DRAWINGS

Fig. 1 is a perspective view showing a solar energy generation system including solar modules according to an embodiment of the present invention.
Fig. 2 is a rear view showing a schematic configuration of a solar module according to the embodiment of the present invention.
Fig. 3 is a cross sectional perspective view showing a schematic configuration of solar modules according to the embodiment of the present invention.
Fig. 4 is a schematic view showing a solar array including solar modules in a connected state according to the embodiment of the present invention.
Fig. 5 is a cross sectional view showing a schematic configuration of solar module connectors according to the embodiment of the present invention.
Fig. 6 is a cross sectional view showing a schematic configuration of solar module connectors in an engagement stand-by state according to the embodiment of the present invention.
Fig. 7 is a cross sectional view showing a schematic configuration of solar module connectors in a complete engagement state according to the embodiment of the present invention.
Fig. 8 is a cross sectional view showing a schematic configuration of a solar module connectors in another example according to the embodiment of the present invention.
Fig. 9 is a cross sectional view showing a schematic configuration of solar module connectors in another example according to the embodiment of the present invention.
Fig. 10 is a rear view showing a schematic configuration of a solar module in another example according to the embodiment of the present invention.
Fig. 11 is a rear view showing a schematic configuration of a solar module in still another example according to the embodiment of the present invention.
Fig. 12 is a schematic view showing a solar module string.

### DETAILED DESCRIPTION

A solar energy generation system generating 1 MW power or higher, which is so-called a mega solar system, includes a solar array of a combination of thousands or more solar modules having a capacity of generating several dozen W power. In the case of a solar energy generation system including a huge number of solar modules like the mega solar system, an operation (placement operation) for placing solar modules on support bases is first conducted over several consecutive days. Then, connectors between solar modules placed on the support bases are connected (connector connection operation), and all or some of solar module strings are assembled. These operations are repeated to complete a solar array.

When the solar energy generation system is constructed in a marine coast area, solar modules are exposed to an atmosphere which is high in sea salt particle density and high in humid. If the solar modules with connectors unconnected are left unattended for one day or several days (for example, during a period from the placement operation to the connector connection operation in a mega solar system), sea salt particles may possibly attach to insides of the connectors, particularly to contact points (pin inserts and socket inserts), and the connectors may be connected with the sea salt particles adhering to the connectors due to humidity in the air and remaining therein.

If the connectors are connected while the sea salt particles remain inside, degradation such as rust and corrosion occurs in the contact points inside the connectors, lead wires of cables connected to the contact points, and surrounding members. Such degradation leads to a failure of conduction resistance between solar modules and a failure of insulation resistance of the solar modules, and causes short circuit and heat generation as well as degradation in a resin portion associated with the heat generation. As degradation in the resin portion progresses, the resin portion may be hardened, cracked or carbonized, and moisture may enter into the resin portion through a damaged portion thereof, and this may result in occurrence of burnout.

On one hand, attachment of sea salt particles to the inside of the connector can be prevented by connecting a positive electrode connector with a negative electrode connector in a single solar module before connection of connectors between adjacent solar modules (i.e., before the connector connection operation). In conventional solar module connectors, connecting between a positive electrode connector and a negative electrode connector establishes electric connection between contact points in the connector.

However, a solar module having the positive electrode connector connected to the negative electrode connector has a short-circuited output upon reception of light. A short-circuit current of a solar module including a crystal-based solar cell is about 1.2 times or less of optimum operating current obtained when the solar cell generates maximum power. The magnitude of the short-circuit current itself does not pose a serious problem. However, if connection between connectors is broken, i.e., connection between contact points is broken while the short-circuit current passes, arc discharge may locally occur and damage the contact points, which may hinder re-connection. On the other hand, in the case of a solar module including an amorphous-based solar cell, a high ratio of the short-circuit current to the optimum operating current is not preferable as it may accelerate degradation of the solar cell itself.

It is also possible to mount connector caps on the connectors to prevent invasion of sea salt particles. However, the connector caps are not preferable either because they end up as wastes twice as large in quantity as the solar module.

Accordingly, an object of the present invention is to provide a solar module and a solar module connector which is less susceptible to invasion of foreign materials, such as sea salt particles, into the connector without putting the solar module in an output short-circuit state.

In order to solve the aforementioned problem, a solar module connector according to an embodiment of the present invention is a solar module connector for electrically connecting one solar module with another solar module to form a solar array, including: a first contact point configured to electrically connect with one of a positive electrode and a negative electrode of the solar module; a jack housing configured to surround the first contact point; a second contact point configured to electrically connect with another of the positive electrode and the negative electrode of the solar module; and a plug housing configured to surround the second contact point and to be engageable with the jack housing in a first engagement state where the first contact point and the second contact point are covered in a non-conductive state and in a generally airtight manner in cooperation with the jack housing or in a second engagement state where the first contact point and the second contact point are covered in a conductive state and in a generally airtight manner.

A solar module according to an embodiment of the present invention is a solar module to form a solar array by electrically connecting one solar module with another solar module, including: a first contact point configured to electrically connect with one of a positive electrode and a negative electrode of the solar module; a jack housing configured to surround the first contact point; a second contact point configured to electrically connect with another of the positive electrode and the negative electrode of the solar module; and a plug housing configured to surround the second contact point and to be engageable with the jack housing in a first engagement state where the first contact point and the second contact point are covered in a non-conductive state and in a generally airtight manner in cooperation with the jack housing or in a second engagement state where the first contact point and the second contact point are covered in a conductive state and in a generally airtight manner.

Further, a solar module according to an embodiment of the present invention is a solar module to form a solar array by electrically connecting one solar module with another solar module, including: a connector for the solar modules; and a stop cap provided in the solar module so as to cover a contact point of the positive electrode connector in a non-conductive state and in a generally airtight manner once the connector is engaged.

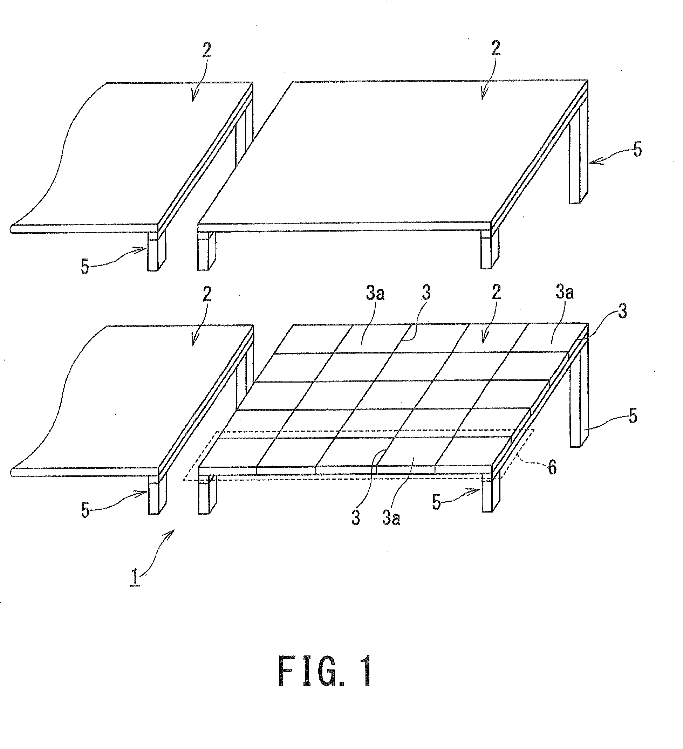

A description is now given of an embodiment of a solar module and a solar module connector according to the present invention with reference to Figs. 1 to 11.

Fig. 1 is a perspective view showing a solar energy generation system including solar modules according to an embodiment of the present invention.

As shown in Fig. 1, a solar energy generation system 1 includes a plurality of solar arrays 2.

The solar array 2 includes one solar module 3 and another solar module 3 that are electrically connected with each other. The solar array 2 includes a support base 5 placed on the ground, and a plurality of the solar modules 3 placed on the support base 5.

The support base 5 has a steel skeleton construction which is made of a plurality of steel materials. The support base 5 supports a plurality of the solar modules 3 aligned in a matrix form and facing the sun.

The solar module 3 generates power upon reception of light on a rectangular-shaped light-receiving surface 3a. Each solar module 3 has a capacity of generating power of several dozen W.

A solar module string 6 includes a plurality of the solar modules 3 electrically connected in series. The solar array 2 includes a plurality of the solar module strings 6 electrically connected in parallel.

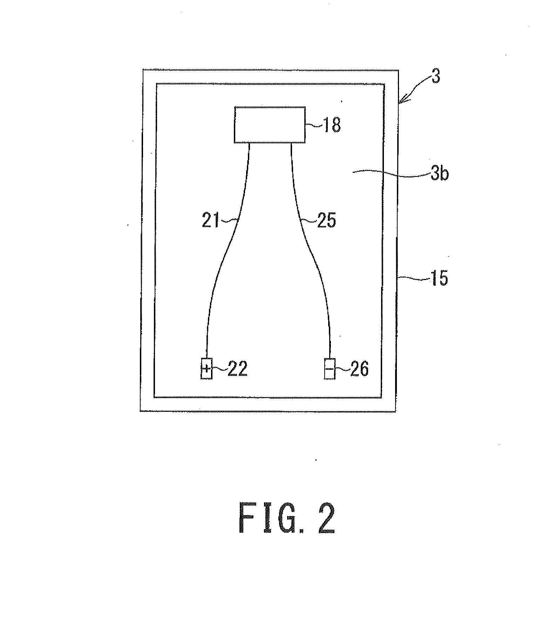

Fig. 2 is a rear view showing a schematic configuration of the solar module according to the embodiment of the present invention.

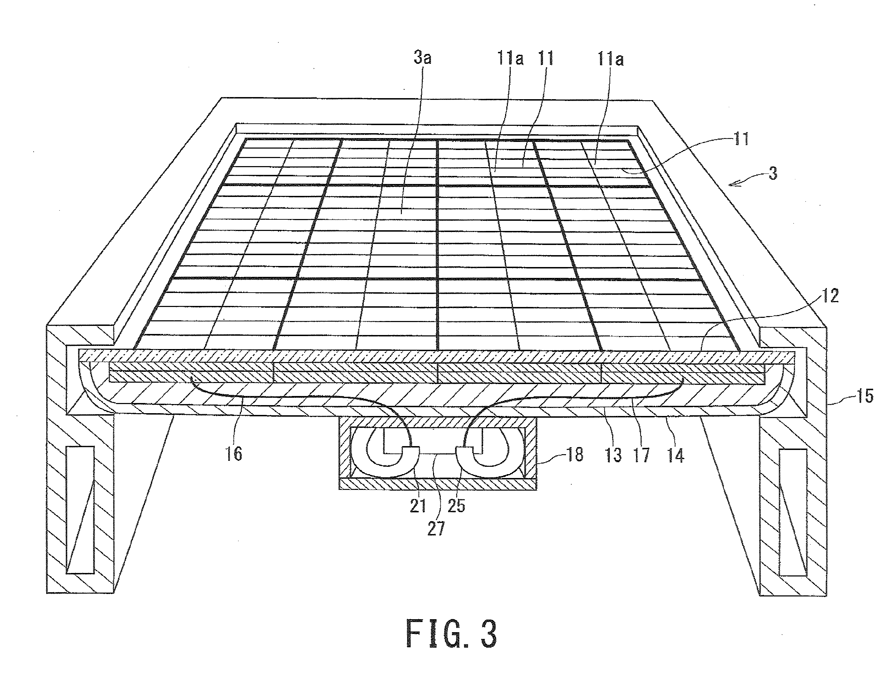

Fig. 3 is a cross sectional perspective view showing a schematic configuration of the solar modules according to the embodiment of the present invention.

As shown in Figs. 2 and 3, the solar module 3 includes flat-shaped solar cells 11 arrayed in a matrix form, a transparent surface protection plate 12 positioned on the side of a light-receiving surface 11a of the solar cells 11, an adhesive resin sealing layer 13 positioned on the side of a non-light receiving surface of the solar cells 11 and having a sufficient adhering and sealing performance, a protective layer 14 covering the adhesive resin sealing layer 13, and an outer frame 15.

The surface protection plate 12, which also serves as a light-receiving surface 3a of the solar module 3, is a plate made of an inorganic material such as a glass plate, or an organic material such as a transparent acrylic plate.

The adhesive resin sealing layer 13 is a layer formed by thermally fusing and sealing an EVA (Ethylene Vinyl Acetate copolymer) for example.

The protective layer 14 is made of resin containing metallic foil made by bonding ethylene monofluoride to both sides of aluminum foil for example. The protective layer 14 may be made of an organic film such as a fluorine film, a composite material having an organic film and metallic foil stuck to each other, and a metal/inorganic material such as a metal plate and a glass plate.

The outer frame 15 may be made of a structural member molded with, for example, an aluminum alloy. The outer frame 15 has a groove in which edge portions of the solar cell 11, the surface protection plate 12, the adhesive resin sealing layer 13, and the protective layer 14 can be fitted and be held.

The solar module 3 also includes a positive electrode lead wire 16 electrically connected with a positive electrode of the solar cell 11, a negative electrode lead wire 17 electrically connected with a negative electrode of the solar cell 11, a terminal box 18 provided on the protective layer 14 to accommodate each terminal of the positive electrode lead wire 16 and the negative electrode lead wire 17, a positive electrode cable 21 which electrically connects with the positive electrode lead wire 16 and extends to the outside of the terminal box 18, a positive electrode connector 22 positioned at a top end of the positive electrode cable 21, a negative electrode cable 25 which electrically connects with the negative electrode lead wire 17 and extends to the outside of the terminal box 18, and a negative electrode connector 26 positioned at a top end of the negative electrode cable 25.

The terminal box 18 is positioned on the side of a non-light receiving surface 3b of the solar module 3. The terminal box 18 accommodates a positive electrode terminal (illustrated omitted) which electrically connects the positive electrode lead wire 16 and the positive electrode cable 21, a negative electrode terminal (illustration omitted) which electrically connects the negative electrode lead wire 17 and the negative electrode cable 25, and a terminal block 27 for holding the positive electrode terminal and the negative electrode terminal.

When the solar modules 3 constitute the solar module string 6, the positive electrode cable 21 and the negative electrode cable 25 have a cable length that can connect adjacent solar modules 3 in series.

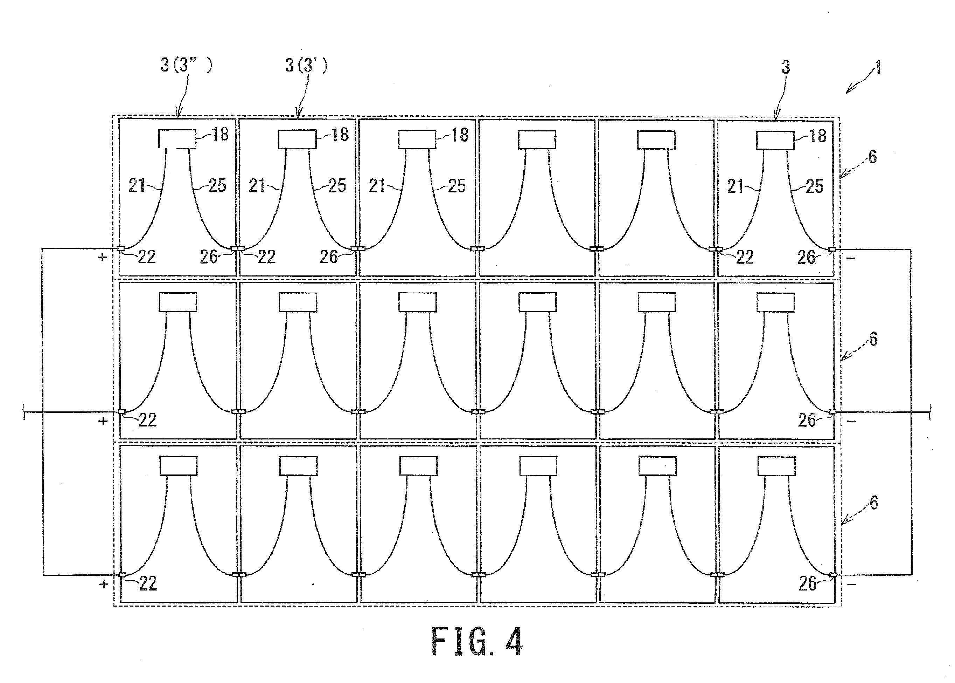

Fig. 4 is a schematic view showing a solar array including solar modules in a connected state according to the embodiment of the present invention.

As shown in Fig. 4, the solar module string 6 in the solar array 2 is formed by bringing close to each other a positive electrode cable 21 extending from the terminal box 18 of one solar module 3 (3') and a negative electrode cable 25 extending from the terminal box 18 of another solar module 3 (3"), and by connecting the positive electrode connector 22 and the negative electrode connector 26 one after another.

The solar array 2 is formed by electrically bundling positive electrode connectors 22 at positive electrode ends of the solar module strings 6 and electrically bundling negative electrode connectors 26 at negative electrode ends of the solar module strings 6.

A power generation capacity of the solar array 2 is adjusted with the number of serially connected solar modules 3 that constitute a solar module string 6 and the number of parallely connected solar module strings 6.

Next, the connectors 22 and 26 of the solar module 3 will be described in detail.

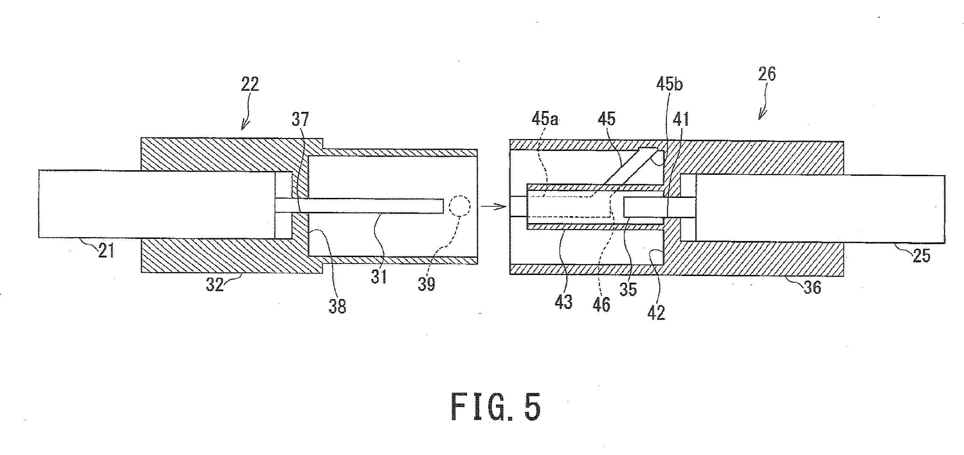

Fig. 5 is a cross sectional view showing a schematic configuration of the solar module connectors according to the embodiment of the present invention.

As shown in Fig. 5, the connectors 22 and 26 of the solar module 3 includes a pin insert 31 electrically connected with the positive electrode of the solar module 3, a jack housing 32 surrounding the pin insert 31, a socket insert 35 electrically connected to the negative electrode of the solar module 3, and a plug housing 36 surrounding the socket insert 35.

In other words, the positive electrode connector 22 includes the pin insert 31 and the jack housing 32, while the negative electrode connector 26 includes the socket insert 35 and the plug housing 36. It is to be noted that combination of the pin insert 31, the jack housing 32, the socket insert 35, and the plug housing 36 in a positive electrode side and a negative electrode side can arbitrarily be replaced with each other. More specifically, the pin insert 31 and the plug housing 36 may be combined as the positive electrode connector 22, while the socket insert 35 and the jack housing 32 may be combined as the negative electrode connector 26. The socket insert 35 and the plug housing 36 may also be combined as the positive electrode connector 22, while the pin insert 31 and the jack housing 32 may be combined as the negative electrode connector 26.

The pin insert 31 and the socket insert 35 are contact points which are attachably/ detachably engaged and thereby electrically connected with each other. One of the inserts is a first contact point and another of the inserts is a second contact point. The pin insert 31 and the socket insert 35 are respectively pressure-bonded and joined to one of core wires of the positive electrode cable 21 and the negative electrode cable 25.

The jack housing 32 is a tube made of hard resin such as nylon. The jack housing 32 includes a partition 38 having an insert holding hole 37 for holding a base end portion of the pin insert 31 (or the socket insert 35) to be fitted. The partition 38 divides a hollow section of the jack housing 32 into two subsections.

One subsection of the hollow section divided by the partition 38 surrounds and holds the positive electrode cable 21 (or the negative electrode cable 25) to be connected with the pin insert 31 (or the socket insert 35). A clearance between the jack housing 32 and the positive electrode cable 21 (or the negative electrode cable 25) is blocked by an adhesive (illustration omitted) or a sealant (illustration omitted). Another subsection of the hollow section divided by the partition 38 surrounds the pin insert 31 protruding and extending from the insert holding hole 37.

The jack housing 32 includes a pin 39 which protrudes to an outer circumference. The pin 39 is positioned on the outer circumference in the vicinity of a top end portion of the jack housing 32 that is to be fitted into the plug housing 36, and extends in a radial direction of the jack housing 32.

The plug housing 36 can engage with the jack housing 32 in an engagement stand-by state (the first engagement state) where the pin insert 31 and the socket insert 35 are covered in a non-conductive state and in a generally airtight manner in cooperation with the jack housing 32 when the jack housing 32 is shallowly engaged, and further in a complete engagement state (the second engagement state) where the pin insert 31 and the socket insert 35 are covered in a conductive state and in a generally airtight manner when the jack housing 32 is deeply engaged. The plug housing 36 is a tube made of hard resin such as nylon. The plug housing 36 includes a partition 42 having an insert holding hole 41 for holding a base end portion of the socket insert 35 (or the pin insert 31) to be fitted. The partition 42 includes a sleeve 43 for auxiliary supporting the socket insert 35 so as to prevent the socket insert 35 from falling down and divides a hollow section of the plug housing 36 into two subsections.

One subsection of the hollow section divided by the partition 42 surrounds and holds the negative electrode cable 25 (or the positive electrode cable 21) to be connected to the socket insert 35 (or the pin insert 31). A clearance between the plug housing 36 and the negative electrode cable 25 (or the positive electrode cable 21) is blocked by an adhesive (illustration omitted) or a sealant (illustration omitted). Another subsection of the hollow section divided by the partition 42 surrounds the sleeve 43 extending from a peripheral edge portion of the insert holding hole 41. The sleeve 43 surrounds the socket insert 35 protruding and extending from the insert holding hole 41.

The plug housing 36 also has a groove 45 in which the pin 39 can be fitted in connection with engagement of the jack housing 32. The groove 45 is positioned on an inner circumference of the another subsection of the hollow section divided by the partition 42. The groove 45 has a first groove section 45a configured to have a refraction portion 46 that runs against the pin 39 for temporarily stopping the jack housing 32 at a shallow engagement position where the jack housing 32 is put in an engagement stand-by state and a second groove section 45b configured to continue with the first groove section 45a to introduce the jack housing to a deep engagement position where the jack housing is put in a complete engagement state.

The first groove section 45a is a groove that linearly extends in a travelling direction (a solid arrow line in Fig. 5) of the jack housing 32 to be engaged with the plug housing 36. The second groove section 45b is a groove that continues with the refraction portion 46 and spirally extends in the travelling direction (the solid arrow line in Fig. 5) of the jack housing 32 to be engaged with the plug housing 36.

The pin 39 and the groove 45 are locking mechanisms for locking the positive electrode connector 22 and the negative electrode connector 26 in the engagement stand-by state or in the complete engagement state.

In the solar energy generation system 1, first, an operation (placement operation) for placing the solar modules 3 on the support bases 5 is continuously conducted over several days. Then, the connectors 22 and 26 between the solar modules 3 placed on the support bases 5 are connected (connector connection operation), and all or some of the solar module strings 6 are assembled. By repeating these operations, a solar array 2 is completed. The pin insert 31, the socket insert 35, and the hollow sections divided by the partitions 38 and 42 in the connectors 22 and 26 of the solar module 3 may possibly be exposed to an atmosphere during a period from the placement operation (or carrying-in before that) to the connector connection operation if no curing is taken.

Accordingly, in the solar module 3 according to this embodiment, the positive electrode connector 22 and the negative electrode connector 26 in the same solar modules 3 are engaged with each other during a period from the placement operation to the connector connection operation or during a period from shipment to the connector connection operation.

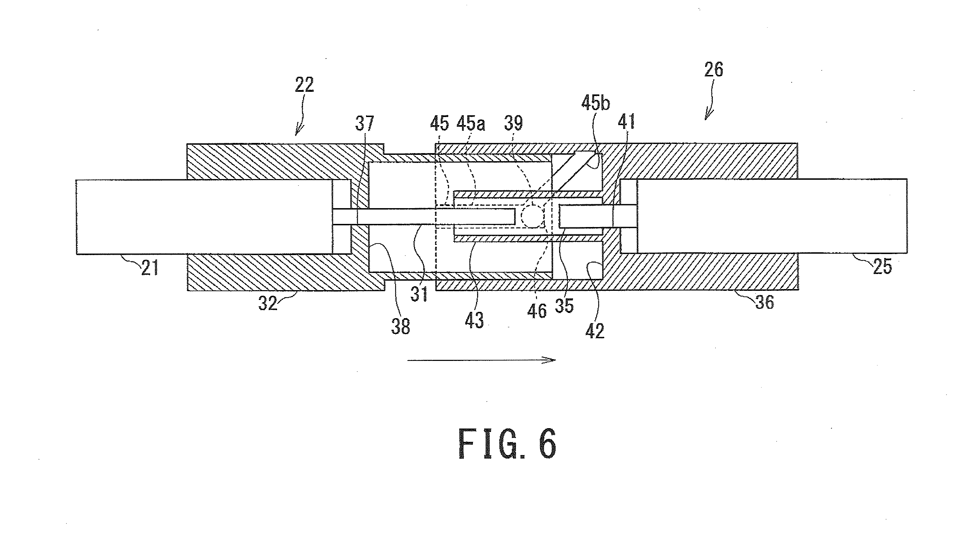

Fig. 6 is a cross sectional view showing a schematic configuration of the solar module connectors in an engagement stand-by state according to the embodiment of the present invention.

As shown in Fig. 6, when the jack housing 32 is linearly engaged with the plug housing 36(in a solid arrow line direction in Fig. 6), the connectors 22 and 26 are such that the pin 39 advances along the first groove section 45a of the groove 45 and runs against the refraction portion 46, so that the jack housing 32 temporarily stops at a shallow engagement position and is put in the engagement stand-by state (the first engagement state).

When the connectors 22 and 26 are in an engagement stand-by state, the pin insert 31 and the socket insert 35 are in the state not in contact with each other, i.e., the positive electrode side and the negative electrode side of the solar module 3 are in a non-conductive state, while the jack housing 32 that is shallowly engaged with the plug housing 36 keeps the peripheries of the pin insert 31 and the socket insert 35 generally airtight with respect to an atmosphere in the connectors 22 and 26. An engagement portion between the plug housing 36 and the jack housing 32 has an engagement dimension for keeping the peripheries of the pin insert 31 and the socket insert 35 generally airtight to prevent invasion of sea salt particles.

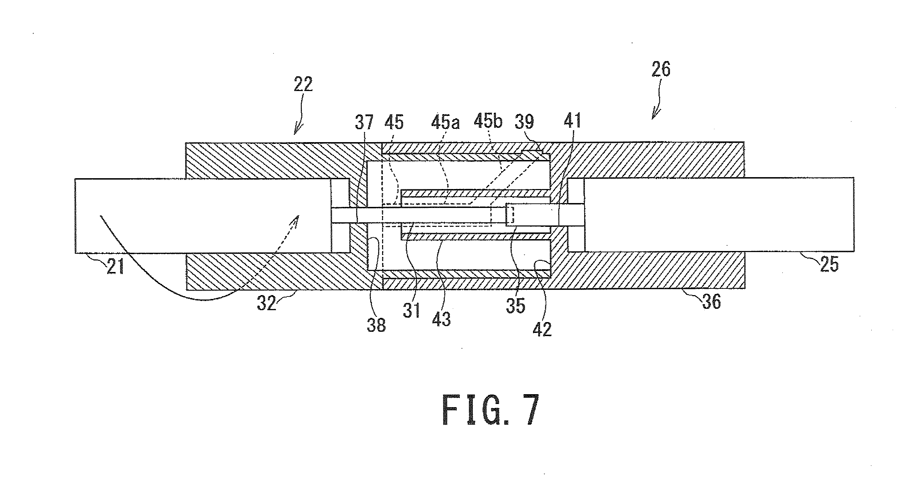

Fig. 7 is a cross sectional view showing a schematic configuration of the solar module connectors in a complete engagement state according to an embodiment of the present invention.

As shown in Fig. 7, as engagement of the connectors 22 and 26 is carried on by screwing the jack housing 32 that is in the engagement stand-by state into the plug housing 36 (a direction drawn with a solid line and a broken arrow line in Fig. 7), the pin 39 advances along the second groove section 45b of the groove 45, and the jack housing 32 reaches a deep engagement position, where the complete engagement state is achieved (the second engagement state).

When the connectors 22 and 26 are in a complete engagement state, the pin insert 31 and the socket insert 35 are in an engagement state, i.e., the positive electrode side and the negative electrode side of the solar module 3 are in a conductive state, while the jack housing 32 that deeply engages with the plug housing 36 keeps the peripheries of the pin insert 31 and the socket insert 35 generally airtight with respect to an atmosphere in the connectors 22 and 26.

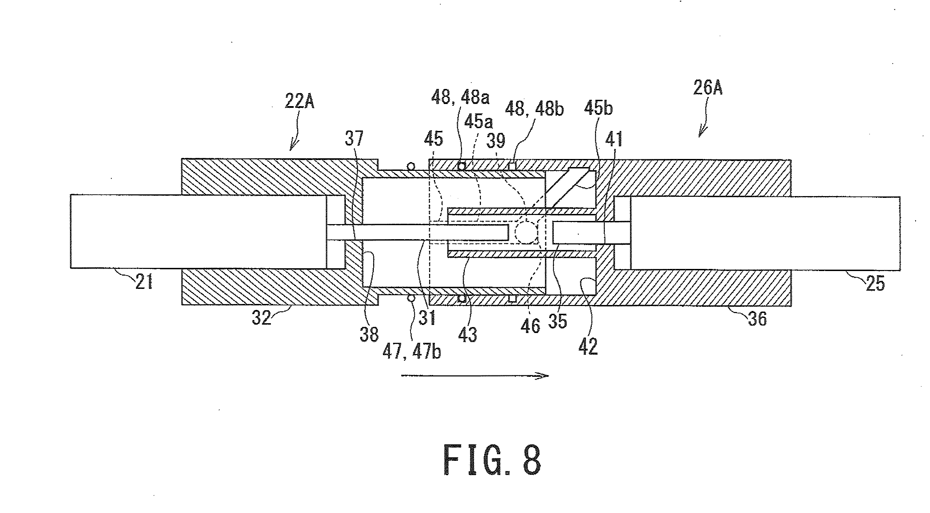

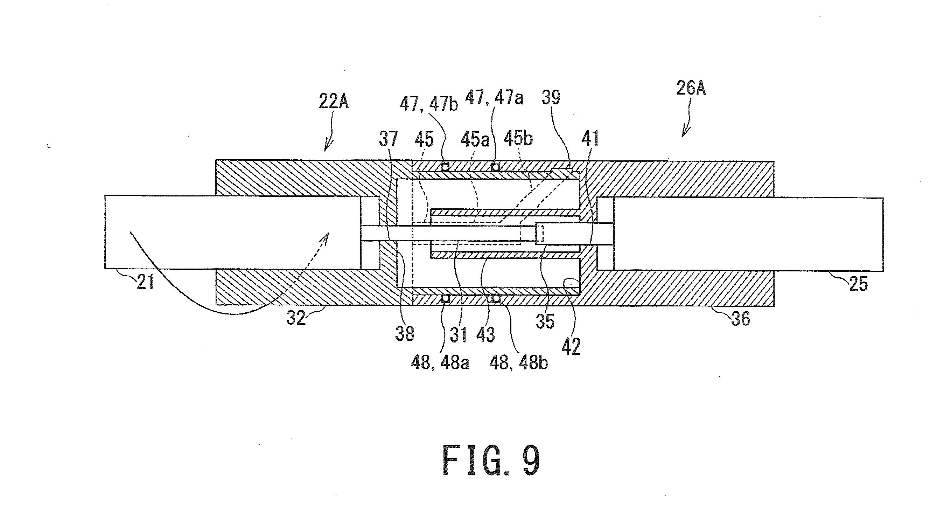

Figs. 8 and 9 are cross sectional views showing a schematic configuration of solar module connectors in another example according to the embodiment of the present invention.

It is to be noted that components in connectors 22A and 26A, which are identical to those of connectors 22 and 26, are denoted by identical reference characters to omit repeated explanation.

As shown in Figs. 8 and 9, the positive electrode connector 22A includes a packing 47 wrapped around a circumferential direction of an outer circumference of a jack housing 32.

A plug housing 36 of the negative electrode connector 26A has a packing groove 48 in which the packing 47 can be fitted to airtightly block a clearance between the jack housing 32 and the plug housing 36 in cooperation with the packing 47.

The packing 47 may be wrapped around a circumferential direction of an inner circumference of the plug housing 36. In that case, the packing groove 48 is formed on the jack housing 32.

The packing 47 and the packing groove 48 have a first packing 47a and a first packing groove 48a that engage with each other when the jack housing 32 and the plug housing 36 shallowly engage in an engagement stand-by state, and have a second packing 47b and a second packing groove 48b that engage with each other when the jack housing 32 and the plug housing 36 deeply engage in a complete engagement state.

More specifically, the packing 47 includes the first packing 47a positioned at a front end side of the jack housing 32 and the second packing 47b positioned at a rear side of the first packing 47a, whereas the packing groove 48 includes the first packing groove 48a positioned at an opening side of the plug housing 36 and the second packing groove 48b positioned at a rear side of the first packing groove 48a.

When the jack housing 32 and the plug housing 36 shallowly engage with each other, the first packing 47a first fits into the first packing groove 48a so that a clearance the between jack housing 32 and the plug housing 36 is airtightly blocked. When the jack housing 32 and the plug housing 36 deeply engage with each other, the first packing 47a first fits into the second packing 47b, and the second packing 47b fits into the first packing groove 48a, so that a clearance between the jack housing 32 and the plug housing 36 is airtightly blocked.

The connectors 22A and 26A block an engagement portion between the jack housing 32 and the plug housing 36 with the packing 47 and the packing groove 48, and keeps the peripheries of the pin insert 31 and the socket insert 35 airtight with respect to an atmosphere regardless of accuracy in the engagement dimension.

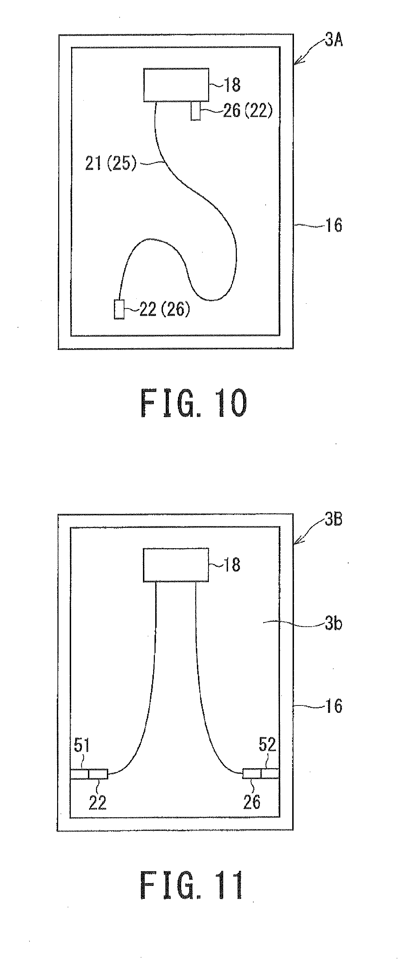

Fig. 10 is a rear view showing a schematic configuration of a solar module in another example according to the embodiment of the present invention.

It is to be noted that components in a solar module 3A, which are identical to those in the solar module 3, are denoted by identical reference characters to omit repeated explanation.

As shown in Fig. 10, the solar module 3A includes a positive electrode cable 21 (or a negative electrode cable 25) extending from the terminal box 18, but the negative electrode cable 25 (or the positive electrode cable 21) does not extend to the outside of the terminal box 18. Instead, the solar module 3A includes a negative electrode connector 26 (or a positive electrode connector 22) integrally fixed to the terminal box 18. The positive electrode cable 21 (or the negative electrode cable 25) of the solar module 3A has a cable length connectable with the negative electrode connector 26 (or the positive electrode connector 22) of an adjacent solar module 3A.

Fig. 11 is a rear view showing a schematic configuration of a solar module in still another example according to the embodiment of the present invention.

It is to be noted that components in a solar module 3B, which are identical to those in the solar module 3, are denoted by identical reference characters to omit repeated explanation.

As shown in Fig. 11, the solar module 3B includes resting caps 51 and 52 provided in the solar module 3B so as to cover the pin insert 31 or the socket insert 35 in a non-conductive state and in a generally airtight manner when the connectors 22 and 26 are engaged with each other.

The resting caps 51 and 52 are caps which can respectively be engaged with the positive electrode connector 22 or the negative electrode connector 26 in an attachable/ detachable manner. The resting caps 51 and 52 are fixed to or integrally molded with one of a non-light receiving surface 3b and the outer frame 15 of the solar module 3B.

In the solar module 3B according to the present embodiment, during a period from the placement operation to the connector connection operation or during a period from shipment to the connector connection operation, the positive electrode connector 22 and the negative electrode connector 26 in the same solar module 3 are capped with the resting caps 51 and 52 so as to put the solar module 3B in an idle state.

The solar modules 3 and 3A and the connectors 22, 26, 22A, and 26A according to the present embodiment have an engagement stand-by state where contact points on the positive electrode side and the negative electrode side are closed in a non-conductive state and in an airtight manner, and have a complete engagement state where the contact points on the positive electrode side and the negative electrode side are closed in a conductive state and in an airtight manner. Accordingly, it becomes possible to prevent attachment and adherence of sea salt particles, to protect the contact points, the positive electrode cable 21, the negative electrode cable 25, or the peripheries thereof from degradation such as rust and corrosion, and to successfully maintain conduction resistance between solar modules 3 and 3A and insulation resistance of the solar modules 3 and 3A. This function of preventing attachment and adherence of sea salt particles is particularly effective when the solar energy generation system 1 is constructed in a marine coast area.

In the solar module 3B according to the present embodiment, the resting caps 51 and 52 for closing the contact points on the positive electrode side and the negative electrode side in a non-conductive state and in an airtight manner make it possible to prevent attachment and adherence of sea salt particles, to protect the contact points, the positive electrode cable 21, the negative electrode cable 25, or the peripheries thereof from degradation such as rust and corrosion, and to successfully maintain conduction resistance between solar modules 3B and insulation resistance of the solar module 3B.

Further, the solar modules 3, 3A and 3B, and the connectors 22, 26, 22A, and 26A according to this embodiment have an engagement stand-by state or an idle state, which avoids the output short-circuit state of the solar modules 3, 3A, and 3B and prevents burnout of peripheries of the solar modules due to degradation of the solar cells themselves and occurrence of local arc discharge.

Furthermore, in the solar module 3B according to this embodiment, the resting caps 51 and 52 for putting the connectors 22, 26, 22A, and 26A into an idle state are fixed to or integrally molded with the solar module 3B, so that generation of wastes is prevented.

Therefore, according to the solar modules 3, 3A, and 3B and the connectors 22, 26, 22A, and 26A in the present embodiment, the solar modules 3, 3A, and 3B are not put in an output short circuit state, and foreign materials, such as sea salt particles, are less likely to enter into the connectors 22, 26, 22A, and 26A.

While certain embodiments have been described, these embodiments have been presented by way of example only, and are not intended to limit the scope of the invention. Indeed, the novel apparatuses and units described herein may be embodied in a variety of other forms; furthermore, various omissions, substitutions and changes in the form of the apparatuses and units described herein may be made without departing from the spirit of the invention. The accompanying claims and their equivalents are intended to cover such forms or modifications as would fall within the scope and spirit of the invention.

### Description of Symbols

- 1: solar energy generation system
- 2: solar array
- 3, 3A, 3B: solar module
- 3a: light-receiving surface
- 3b: non-light receiving surface
- 5: support base
- 6: solar module string
- 11: solar cell
- 12: surface protection plate
- 13: adhesive resin sealing layer
- 14: protective layer
- 15: outer frame
- 16: positive electrode lead wire
- 17: negative electrode lead wire
- 18: terminal box
- 21: positive electrode cable
- 22, 22A: positive electrode connector
- 25: negative electrode cable
- 26 26A: negative electrode connector
- 27: terminal block
- 31: pin insert
- 32: jack housing
- 35: socket insert
- 36: plug housing
- 37: insert holding hole
- 38: partition
- 39: pin
- 41: insert holding hole
- 42: partition
- 43: sleeve
- 45: groove
- 45a: first groove section
- 45b: second groove section
- 46: refraction portion
- 47: packing
- 47a: first packing
- 47b: second packing
- 48: packing groove
- 48a: first packing groove
- 48b: second packing groove
- 51, 52: resting caps
- 101: solar module string
- 102: solar module
- 105: positive electrode cable
- 106: positive electrode connector
- 107: negative electrode cable
- 108: negative electrode connector

## Claims

1. A solar module connector for electrically connecting one solar module with another solar module to form a solar array, comprising:
a first contact point configured to electrically connect with one of a positive electrode and a negative electrode of the solar module;
a jack housing configured to surround the first contact point;
a second contact point configured to electrically connect with another of the positive electrode and the negative electrode of the solar module; and
a plug housing configured to surround the second contact point and to be engageable with the jack housing in a first engagement state where the first contact point and the second contact point are covered in a non-conductive state and in a generally airtight manner in cooperation with the jack housing or in a second engagement state where the first contact point and the second contact point are covered in a conductive state and in a generally airtight manner.

2. The solar module connector according to claim 1, comprising
a pin configured to protrude to an outer circumference of the jack housing, wherein
the plug housing has a groove in which the pin is fitted in connection with engagement of the jack housing, and
the groove has a first groove section configured to have a refraction portion that runs against the pin for temporarily stopping the jack housing at an engagement position where the jack housing is put in the first engagement state and a second groove section configured to connect with the first groove section to introduce the jack housing to an engagement position where the jack housing is put in the second engagement state.

3. The solar module connector according to claim 2, wherein
the first groove section linearly extends in a travelling direction of the jack housing to be engaged with the plug housing, and
the second groove section connects with the refraction portion and spirally extends in the travelling direction of the jack housing.

4. The solar module connector according to any one of claims 1 to 3, comprising
a packing configured to be wrapped around a circumferential direction of one of an outer circumference of the jack housing and an inner circumference of the plug housing, wherein
another of the jack housing and the plug housing has a packing groove in which the packing is fitted to airtightly block a clearance between the jack housing and the plug housing in cooperation with the packing.

5. The solar module connector according to claim 4, wherein
the packing and the packing groove have a first packing and a first packing groove that engage with each other when the jack housing and the plug housing engage in the first engagement state, and a second packing and a second packing groove that engage with each other when the jack housing and the plug housing engage in the second engagement state.

6. A solar module to form a solar array by electrically connecting one solar module with another solar module, comprising:
a first contact point configured to electrically connect with one of a positive electrode and a negative electrode of the solar module;
a jack housing configured to surround the first contact point;
a second contact point configured to electrically connect with another of the positive electrode and the negative electrode of the solar module; and
a plug housing configured to surround the second contact point and to be engageable with the jack housing in a first engagement state where the first contact point and the second contact point are covered in a non-conductive state and in a generally airtight manner in cooperation with the jack housing or in a second engagement state where the first contact point and the second contact point are covered in a conductive state and in a generally airtight manner.

7. A solar module to form a solar array by electrically connecting one solar module with another solar module, comprising:
a connector for the solar module; and
a resting cap provided in the solar module so as to cover a contact point of the positive electrode connector in a non-conductive state and in a generally airtight manner once the connector is engaged.
